# EUROPEAN PATENT SPECIFICATION

(11) **EP 3 754 382 B1**
(45) Date of publication and mention of the grant of the patent: **25.10.2023**
(21) Application number: 19180434.3
(22) Date of filing: 17.06.2019
(51) Int. Cl.: G01T 1/20

(54) **RADIATION DETECTOR AND METHOD FOR MANUFACTURING THEREOF**
STRAHLUNGSDETEKTOR UND VERFAHREN ZUR HERSTELLUNG DAVON
DÉTECTEUR DE RAYONNEMENT ET SON PROCÉDÉ DE FABRICATION

(43) Date of publication of application: 23.12.2020
(73) Proprietor: Detection Technology Oyj, 90590 Oulu (FI)
(72) Inventor: Winkler, Alex, 02150 Espoo (FI)
(74) Representative: Papula Oy

(56) References cited:
- EP-A1- 2 866 057
- EP-A1- 3 447 538
- WO-A1-2017/025888
- JP-A- 2002 139 568
- JP-A- 2003 232 860
- US-A1- 2016 154 120

## Description

### TECHNICAL FIELD

The present disclosure relates to radiation detectors, and more particularly to a radiation detector and a method for manufacturing a radiation detector.

### BACKGROUND

Scintillator-based detectors may be used to detect ionising radiation, such as x-ray radiation, gamma radiation, alpha radiation, beta radiation, and neutron radiation. A scintillator-based detector may comprise a scintillator layer and a photodiode layer. The scintillator layer may convert incident ionising radiation into non-ionising radiation, and the photodiode layer may in turn convert the non-ionising radiation into an electrical current that can be detected. US2016/154120 A1 discloses a radiation detector, comprising:a photodiode layer comprising at least one pixel; and a scintillator layer comprising at least one geometrical shape comprising a scintillating material and a polymer, wherein the scintillating material is configured to convert incident ionising radiation into non-ionising electromagnetic radiation, and wherein the geometrical shape is configured to guide at least part of the converted electromagnetic radiation into the at least one pixel using internal reflection. It also discloses also that the manufacturing of such a radiation detector is done using a 3D printing technique.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

It is an object to provide a radiation detector and method for manufacturing a radiation detector. The foregoing and other objects are achieved by the features of the independent claims. Further implementation forms are apparent from the dependent claims, the description and the figures.

According to the invention, there is provided a radiation detector as defined in claim 1. Since the at least one geometrical shape comprises a polymer, it may be possible to produce the at least one geometrical shape using 3D printing. This may enable shaping the at least one geometrical shape with reduced manufacturing costs.

Still according to the claimed invention, the at least one geometrical shape is configured to guide the converted electromagnetic radiation into the at least one pixel using reflections inside the at least one geometrical shape. With such configuration, the at least one geometrical shape may enable enhanced guiding of the converted electromagnetic radiation into the pixels using total internal reflection (TIR).

In a further implementation form of the first aspect, the at least one geometrical shape further comprises a reflective layer situated on a surface of the at least one geometrical shape comprising a material that is reflective to the converted electromagnetic radiation. With such configurations, the at least one geometrical shape may be able to guide the converted electromagnetic radiation into the pixels with improved efficiency.

In a further implementation form of the first aspect, the at least one geometrical shape comprises a first surface and a second surface opposing the first surface, wherein a surface area of the first surface is greater than a surface area of the second surface, and wherein the second surface is closer to the photodiode layer than the first surface. With such configurations, the at least one geometrical shape can, for example, increase the effective surface area of each pixel.

In a further implementation form of the first aspect, the at least one geometrical shape comprises a first surface and a second surface, wherein the first surface and/or the second surface is substantially convex. With such configurations, the at least one geometrical shape may guide the converted electromagnetic radiation into the pixels using the convex surface.

In a further implementation form of the first aspect, the first surface or the second surface is in contact with the photodiode layer. With such configurations, the converted electromagnetic radiation may, for example, transfer efficiently from the at least one geometrical shape into the pixels.

In a further implementation form of the first aspect, the at least one geometrical shape comprises a height and a width and a ratio between the height and the width is greater than one. With such configurations, the conversion efficiency of the at least one geometrical shape may be improved.

According to the invention, as defined in claim 1, a refractive index of the at least one geometrical shape varies in a plane of the photodiode layer. The varying refractive index may enhance guiding of the converted electromagnetic radiation into the at least one pixel.

In a further implementation form of the first aspect, the polymer comprises at least one of: acrylonitrile butadiene styrene; polylactic acid; polyvinyl alcohol; polyethylene terephthalate; polyethylene terephthalate copolyester; high impact polystyrene; nylon; or thermoplastic elastomer. With such configurations, it may be possible to 3D print the at least one geometrical shape using traditional 3D printing procedures and/or equipment.

In a further implementation form of the first aspect, the at least one geometrical shape comprises a first geometrical shape and a second geometrical shape, wherein the first geometrical shape comprises a first scintillating material, and wherein the second geometrical shape comprises a second scintillating material. With such configurations, it may be possible to detect different wavelength ranges using the same detector.

In a further implementation form of the first aspect, the first scintillating material is configured to convert a first wavelength range of the ionising radiation into a first non-ionising electromagnetic radiation, and wherein the second scintillating material is configured to convert a second wavelength range of the ionising radiation into a second non-ionising electromagnetic radiation. With such configurations, it may be possible to detect different wavelength ranges using the same detector.

In a further implementation form of the first aspect, the polymer comprises the scintillating material. With such configurations, it may be possible to utilise scintillating properties of the polymer itself for converting the ionising radiation into the non-ionising electromagnetic radiation.

According to the invention, there is provided a method for manufacturing a radiation detector as defined in claim 11. With such a method, it may be possible to shape the at least one geometrical shape with improved accuracy and/or reduced manufacturing costs.

In an implementation form of the second aspect, the method further comprises adding, before the 3D printing, the scintillating material into the polymer.

In a further implementation form of the second aspect, the 3D printing is performed using one of: stereolithography; binder jetting; fused deposition modelling; digital light processing; selective laser sintering; or laminated object manufacturing.

Still according to the invention as defined by claim 11, the at least one geometrical shape is configured to guide the converted electromagnetic radiation into the at least one pixel using reflections inside the geometrical shape.

Many of the attendant features will be more readily appreciated as they become better understood by reference to the following detailed description considered in connection with the accompanying drawings.

### DESCRIPTION OF THE DRAWINGS

In the following, example embodiments are described in more detail with reference to the attached figures and drawings, in which:
Fig. 1 illustrates a schematic representation of a cross-sectional view of a radiation detector according to an embodiment;
Fig. 2 illustrates a schematic representation of a perspective view of a radiation detector according to an embodiment;
Fig. 3 illustrates a schematic representation of a perspective view of a radiation detector according to an embodiment;
Fig. 4 illustrates a schematic representation of a cross-sectional view of a radiation detector according to an embodiment;
Fig. 5 illustrates a schematic representation of a perspective view of a radiation detector according to an embodiment;
Fig. 6 illustrates a schematic representation of a cross-sectional view of a radiation detector according to an embodiment;
Fig. 7a illustrates a schematic representation of a cross-sectional view of a radiation detector according to an embodiment;
Fig. 7b illustrates a schematic representation of a cross-sectional view of a radiation detector according to another embodiment;
Fig. 8 illustrates a schematic representation of a perspective view of a radiation detector according to an embodiment;
Fig. 9 illustrates a schematic representation of a cross-sectional view of a radiation detector according to an embodiment;
Fig. 10 illustrates a schematic representation of a cross-sectional view of a radiation detector according to an embodiment; and
Fig. 11 illustrates a flow chart representation of a method for manufacturing a radiation detector according to an embodiment.

In the following, identical reference signs refer to identical or at least functionally equivalent features.

### DETAILED DESCRIPTION

In the following description, reference is made to the accompanying drawings, which form part of the disclosure, and in which are shown, by way of illustration, specific aspects in which the present disclosure may be placed. It is understood that other aspects may be utilized and structural or logical changes may be made without departing from the scope of the present disclosure. The following detailed description, therefore, is not to be taken in a limiting sense, as the scope of the present disclosure is defined be the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. On the other hand, for example, if a specific apparatus is described based on functional units, a corresponding method may include a step performing the described functionality, even if such step is not explicitly described or illustrated in the figures. Further, it is understood that the features of the various example aspects described herein may be combined with each other, unless specifically noted otherwise.

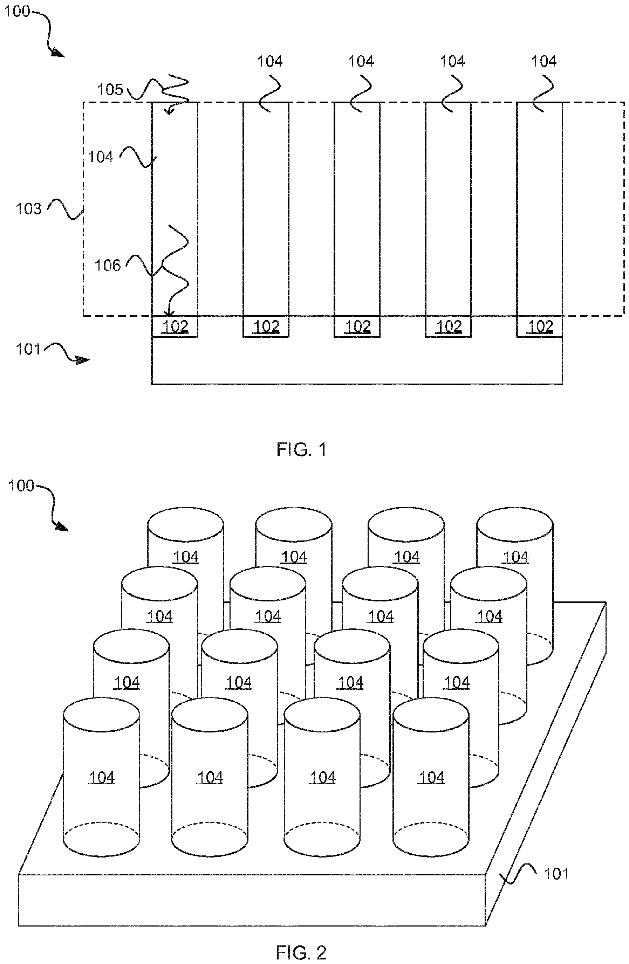

Fig. 1 illustrates a schematic representation of a cross-sectional view of a radiation detector 100 according to an embodiment.

According to an embodiment, the radiation detector 100 comprises a photodiode layer 101 comprising at least one pixel 102; and a scintillator layer 103 comprising at least one geometrical shape 104 comprising a scintillating material and a polymer. The scintillating material is configured to convert incident ionising radiation 105 into non-ionising electromagnetic radiation 106. The geometrical shape 104 is configured to guide at least part of the converted electromagnetic radiation 106 into the at least one pixel 102.

Since the at least one geometrical shape 104 comprises a polymer, the at least one geometrical shape 104 may be produced using 3D printing. This may enable various shapes for the at least one geometrical shape 104 that can enhance the guiding of the converted electromagnetic radiation 106 into the at least one pixel 102.

According to an embodiment, the at least one geometrical shape 104 comprises a height and a width and a ratio between the height and the width is greater than one. The ratio may refer to the height divided by the width. Thus, the height may be greater than the width. The height may be measured in a direction substantially perpendicular to the plane of the photodiode layer 101. The width may be measured substantially in the plane of the photodiode layer 101. Due to the height of the at least one geometrical shape 104, the geometrical shape 104 may be able to convert more of the ionising radiation 105 into the non-ionising radiation 106. Alternatively or additionally, the ratio between the height and the width may be greater than, for example, 2, 3, 4, 5, 6, 7, 8, 9, or 10.

According to an embodiment, the at least one geometrical shape 104 is configured to guide the converted electromagnetic radiation 106 into the at least one pixel 102 using reflections inside the geometrical shape 104. Since the refractive index of the material of the at least one geometrical shape 104 may be larger than the refractive index of the surrounding material, such as air, the converted electromagnetic radiation 106 may undergo one or more total internal reflections (TIR) inside the geometrical shape 104. Thus, TIR may guide the converted electromagnetic radiation 106 into the at least one pixel 102.

According to an embodiment, the polymer comprises the scintillating material. The polymer itself may have scintillating properties. Alternatively or additionally, a scintillating material may be added to the polymer. The scintillating material may be, for example, in powder form before it is added to the polymer.

Herein, the term "ionising radiation" may refer to, for example, x-ray radiation, gamma ray radiation, alpha radiation, or beta radiation. The wavelength of the ionising radiation 105 may be, for example, less than 1 nm. The ionising radiation 105 may comprise various wavelengths.

Fig. 2 illustrates a schematic representation of a perspective view of a radiation detector 100 according to an embodiment. The radiation detector 100 illustrated in the embodiment of Fig. 2 may be similar to the radiation detector 100 illustrated in the embodiment of Fig. 1.

The at least one geometrical shape 104 may comprise, for example, pillars. An example such pillars are illustrated in the embodiments of Fig. 1 and Fig. 2. As ionising radiation 105 enters the at least one geometrical shape 104, scintillating material in the at least one geometrical shape 104 can convert the ionising radiation 105 into non-ionising electromagnetic radiation 106. The non-ionising radiation 106 may have a longer wavelength than the ionising radiation 105.

The converted electromagnetic radiation 106 may be referred to as non-ionising radiation, converted non-ionising radiation, non-ionising electromagnetic radiation, converted electromagnetic radiation, converted non-ionising radiation, or similar.

The converted electromagnetic radiation 106 may be, for example, non-ionising electromagnetic radiation. The converted electromagnetic radiation 106 may comprise, for example, infrared (IR) radiation, visible light (VIS) and/or ultraviolet (UV) radiation. The wavelength of the converted electromagnetic radiation 106 may be longer than the wavelength of the ionising radiation 105. For example, the wavelength of the converted electromagnetic radiation may be in the range 100 micrometres (µm) - 10 nanometres (nm). The converted electromagnetic radiation 106 may comprise electromagnetic radiation of various wavelengths.

The conversion efficiency of the at least one geometrical shape 104 may be configured using the height of the at least one geometrical shape 104.

Since the refractive index of the at least one geometrical shape 104 may be greater than the refractive index of the surrounding material, such as air, the converted electromagnetic radiation 106 may experience reflections inside the at least one geometrical shape 104. Thus, at least part of the converted electromagnetic radiation 106 may be substantially confined into the at least one geometrical shape 104. Thus, the at least one geometrical shape 104 may guide the converted electromagnetic radiation 106 into the at least one pixel 102. Therefore, the at least one geometrical shape 104 may be configured to function as waveguides for the converted electromagnetic radiation 106. This way, the at least one geometrical shape 104 may reduce leakage/crosstalk of the converted electromagnetic radiation 106 between neighbouring pixels 102.

Although the cross-section of the at least one geometrical shape 104 in the plane of the photodiode layer 101 may be illustrated as circular in the embodiment of Fig. 1, the cross-section of the at least one geometrical shape 104 may be of any shape. The cross-section may be, for example, rectangular, square, triangular, oval, or any polygon.

In some embodiments, the scintillator layer 103 may comprise a plurality of geometrical shapes 104. In some embodiments, the scintillator layer 103 may comprise at least two geometrical shapes 104.

The at least one pixel 102 may be configured to convert the converted electromagnetic radiation 106 into an electric current. A voltage may be applied over the photodiode layer 101, and electron-hole pairs generated in the pixels 102 may be detected as a current.

As a person skilled in the art can appreciate, the at least one pixel 102 may be implemented in various ways. For example, each pixel 102 may comprise n-type semiconductor and rest of the photodiode layer may comprise p-type semiconductor. As a voltage is applied over the pn junction, a current due to electron-hole pairs generated in the pn junction by the converted electromagnetic radiation can be detected. The detector 100 may further comprise other components, such as a bias plate, substrates, integrated circuits, and/or similar, not illustrated in the embodiments of Fig. 1 and Fig. 2.

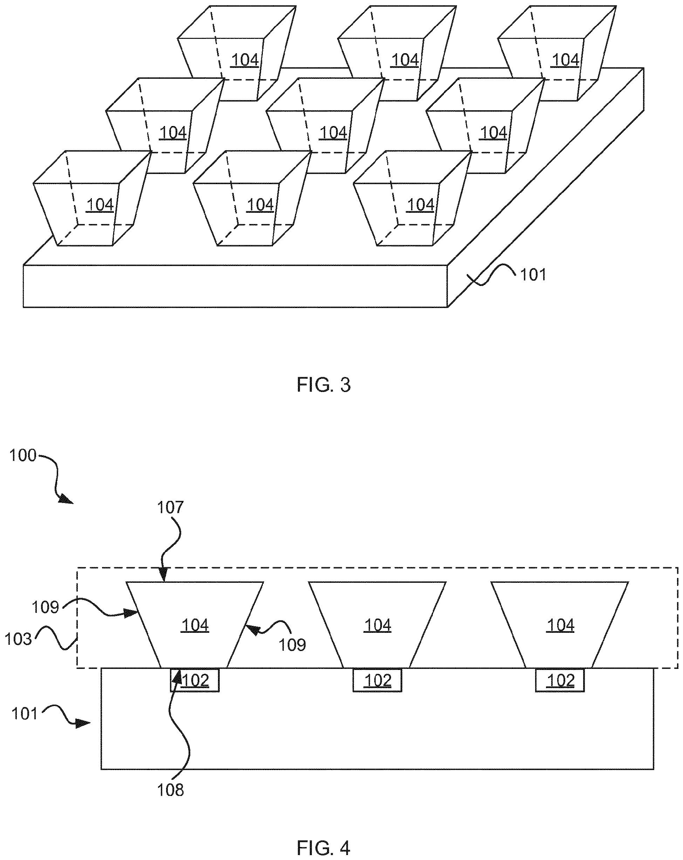

Fig. 3 illustrates a schematic representation of perspective view of a radiation detector 100 according to an embodiment.

Fig. 4 illustrates a schematic representation of a cross-sectional view of a radiation detector 100 according to an embodiment. The radiation detector 100 illustrated in the embodiment of Fig. 4 may be similar to the radiation detector 100 illustrated in the embodiment of Fig. 3.

According to an embodiment, the at least one geometrical shape 104 comprises a first surface 107 and a second surface 108 opposing the first surface 107, wherein a surface area of the first surface 107 is greater than a surface area of the second surface 108, and wherein the second surface 108 is closer to the photodiode layer 101 than the first surface 107.

The at least one geometrical shape 104 may comprise a first surface 107 and a second surface 108. The second surface may be closer to the photodiode layer 101 than the first surface 107. The second surface 108 may be in contact with the photodiode layer 101. The surface area of the first surface 107 may be greater than the surface area of the second surface 108. The first surface 107 and/or the second surface 108 may be substantially parallel with a plane of the photodiode layer 101.

Each of the at least one geometrical shape 104 may be substantially shaped as a square frustum. The embodiment of Fig. 4 illustrates a schematic representation of a cross-section of such geometrical shape 104. The cross-section may be substantially an isosceles trapezoid. Alternatively, the at least one geometrical shape 104 may be shaped as another type of frustum.

Due to the shape of the at least one geometrical shape 104, the scintillator layer 103 may be able to collect more ionizing radiation into the at least one pixel 102. As the scintillating material inside the at least one geometrical shape 104 converts the ionizing radiation into the non-ionising electromagnetic radiation, side surfaces 109 of the at least one geometrical shape 104 may guide the converted electromagnetic radiation into the at least one pixel 102 in the photodiode layer 101. Furthermore, due to the larger surface area of the first surface 107, the at least one geometrical shape 104 may collect more ionising radiation.

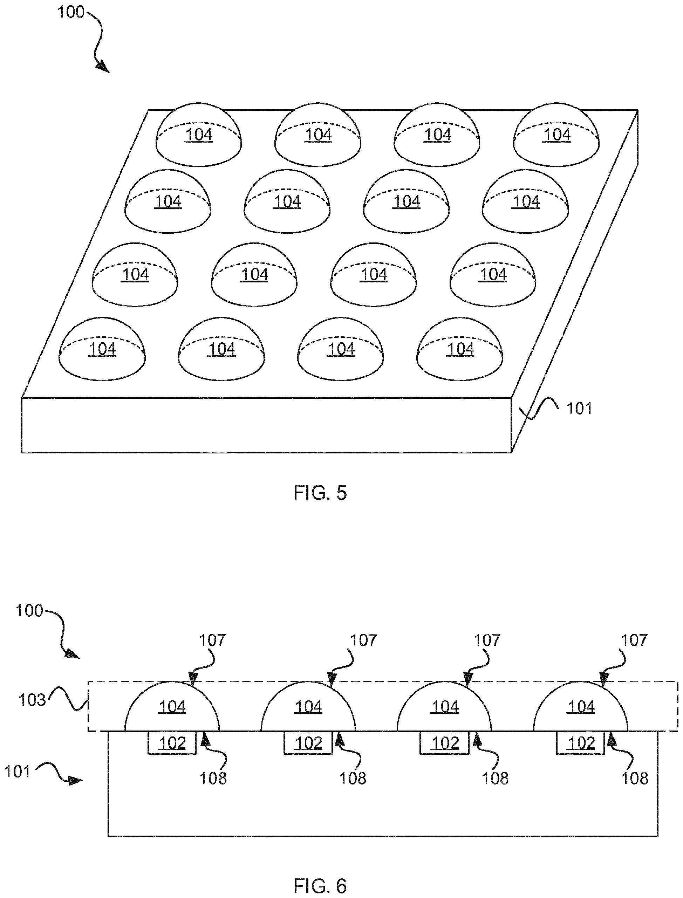

Fig. 5 illustrates a schematic representation of a perspective view of a radiation detector 100 according to an embodiment.

Fig. 6 illustrates a schematic representation of a cross-sectional view of a radiation detector 100 according to an embodiment. The radiation detector 100 illustrated in the embodiment of Fig. 6 may be similar to the radiation detector 100 illustrated in the embodiment of Fig. 5.

According to an embodiment, the at least one geometrical shape 104 comprises a first surface 107 and a second surface 108, wherein the first surface 107 and/or the second surface 108 is substantially convex.

According to a further embodiment, the first surface 107 or the second surface 108 is in contact with the photodiode layer 101.

The at least one geometrical shape 104 may comprise, for example, microlenses. Examples such microlenses are illustrated in the embodiments of Fig. 5 and Fig. 6.

The at least one geometrical shape 104 may comprise a substantially convex first surface 107 and a substantially flat second surface 108. The second surface 108 may be closer to the photodiode layer 101 than the first surface 107. The second surface 108 may be in contact with the photodiode layer 101. The first surface 107 and/or the second surface 108 may be substantially parallel with a plane of the photodiode layer 101.

Due to the substantially convex first surface 107, the at least one geometrical shape 104 may function as plano-convex lens. When the ionising radiation 105 is converted into the non-ionising electromagnetic radiation 106, the converted electromagnetic radiation 106 may propagate in various directions. Since there may be a refractive index difference between the at least one geometrical shape 104 and the material surrounding the at least one geometrical shape 104, the first surface 107 may reflect parts of the converted electromagnetic radiation 106 that propagate away from the photodiode layer 101 back towards the photodiode layer 101. Thus, the pixels 102 in the photodiode layer 101 may be able to collect a larger fraction of the converted electromagnetic radiation 106.

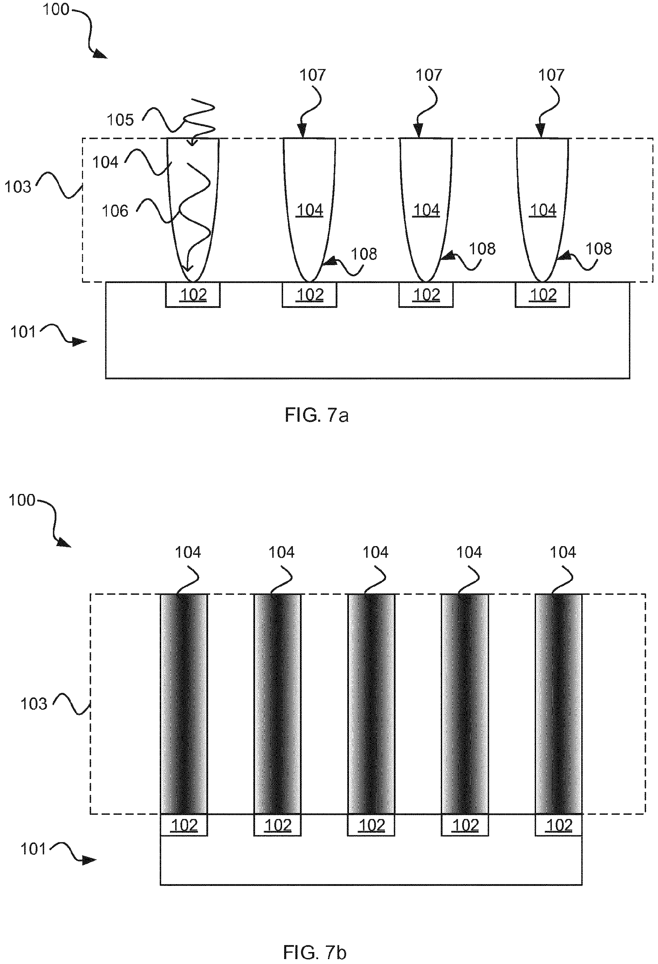

Fig. 7a illustrates a schematic representation of a cross-sectional view of a radiation detector 100 according to an embodiment.

According to an embodiment, the at least one geometrical shape 104 may comprise a substantially flat first surface 107 and a substantially convex second surface 108. The second surface 108 may be closer to the photodiode layer 101 than the first surface 107. The second surface 108 may be in contact with the photodiode layer 101. The first surface 107 and/or the second surface 108 may be substantially parallel with a plane of the photodiode layer 101.

Due to the convex second surface 108, the at least one geometrical shape 104 may function as plano-convex lens. Thus, the converted electromagnetic radiation 106 may be focused by the at least one geometrical shape 104 into the at least one pixel 102.

Fig. 7b illustrates a schematic representation of a cross-sectional view of a radiation detector 100 according to the claimed invention. The gradient inside the at least one geometrical shape 104 corresponds to the refractive index of the material.

According to the claimed invention, a refractive index of the at least one geometrical shape 104 varies in a plane of the photodiode layer 101. The refractive index comprises a gradient in the plane of the photodiode layer 101. The embodiment of Fig. 7b is an example of such a radiation detector 100.

The refractive index of the at least one geometrical shape 104 may vary in at least one direction in the plane of the photodiode layer 101. The refractive index may vary gradually. For example, the refractive index may be lower at outer parts of the geometrical shape 104 than in the middle of the geometrical shape 104. The refractive index may be lower close to the sides of the geometrical shape 104 that are substantially perpendicular to the photodiode layer 101 than in the middle of the geometrical shape 104. For example, if the cross-section of the at least one geometrical shape is substantially circular in the plane of the photodiode layer 101, the refractive index may be radially varying. Such varying refractive index may enhance guiding of the converted electromagnetic radiation 106 into the at least one pixel 102 similarly to the lens structure presented in the embodiment of Fig. 7a.

3D printing may allow to gradually change the refractive index of the at least one geometrical shape 104. This may be achieved by, for example, changing mixing ratios of the printed raw materials.

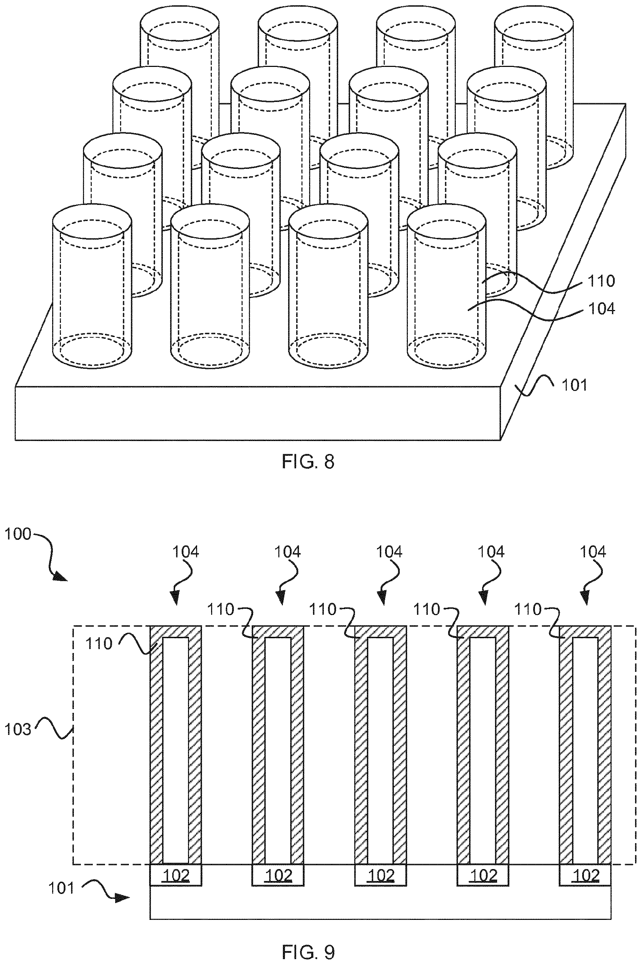

Fig. 8 illustrates a schematic representation of a perspective view of a radiation detector 100 according to an embodiment.

According to an embodiment, the at least one geometrical shape 104 further comprises a reflective layer 110 situated on a surface of the geometrical shape 104 comprising a material that is reflective to the converted electromagnetic radiation.

Fig. 9 illustrates a schematic representation of a cross-sectional view of a radiation detector 100 according to an embodiment. The radiation detector 100 illustrated in the embodiment of Fig. 9 may be similar to the radiation detector 100 illustrated in the embodiment of Fig. 8.

The scintillator layer 103 may further comprise a reflective layer 110. The reflective layer may be situated on the surface of the at least one geometrical shape 104. The embodiments of Fig. 8 and Fig. 9 illustrate such a reflective layer 110 for the aforementioned pillar shapes. However, the reflective layer 110 may be combined with any geometrical shape 104 described herein.

The reflective layer 110 may be reflective at the wavelengths of the converted electromagnetic radiation 106. Thus, the reflective layer 110 may further guide the converted electromagnetic radiation 106 into the pixels 102 in the photodiode layer 101.

The reflective layer 110 may be reflective at all wavelengths of the converted electromagnetic radiation 105 or some wavelengths of the converted electromagnetic radiation 106. Average reflectance of the reflective layer 110 over the wavelengths of the converted electromagnetic radiation 106 may be, for example, greater than 0.1, 0.2, 0.3, 0.4, 0.5, 0.6, 0.7, 0.8, or 0.9.

In some embodiments, the reflective layer 110 may comprise retroreflective material.

In some embodiments, the reflective layer 110 may comprise a material than comprises a refractive index that is less than the reflective index of the material of the geometrical shape 104.

In some embodiments, each geometrical shape 104 may be substantially aligned with a pixel 102 in the photodiode layer 101.

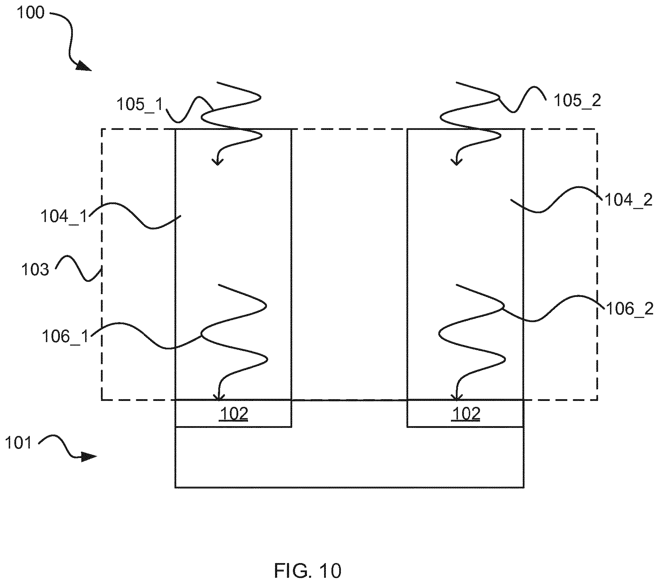

Fig. 10 illustrates a schematic representation of a radiation detector 100 configured for multi-energy imaging according to an embodiment.

According to an embodiment, the at least one geometrical shape comprises a first geometrical shape 104_1 and a second geometrical shape 104_2, wherein the first geometrical shape 104_1 comprises a first scintillating material, and wherein the second geometrical shape 104_2 comprises a second scintillating material.

According to a further embodiment, the first scintillating material is configured to convert a first wavelength range of the ionising radiation 105_1 into a first non-ionising electromagnetic radiation 106_1, and wherein the second scintillating material is configured to convert a second wavelength range of the ionising radiation 105_2 into a second non-ionising electromagnetic radiation 106_2.

The scintillator layer 103 may comprise at least one geometrical shape 104_1, 104_2 comprising different scintillating materials. Thus, the at least one geometrical shape 104_1, 104_2 may be configured to convert different ionising radiation wavelength ranges to the non-ionising electromagnetic radiation 106_1, 106_2.

The converted electromagnetic radiations 106_1, 106_2 may also comprise different wavelengths. For example, a first converted electromagnetic radiation 106_1 may comprise UV wavelengths and a second converted electromagnetic radiation 106_2 may comprise VIS wavelengths or vice versa. Alternatively or additionally, the converted electromagnetic radiations 106_1, 106_2 may comprise substantially same wavelengths and/or their wavelengths may overlap.

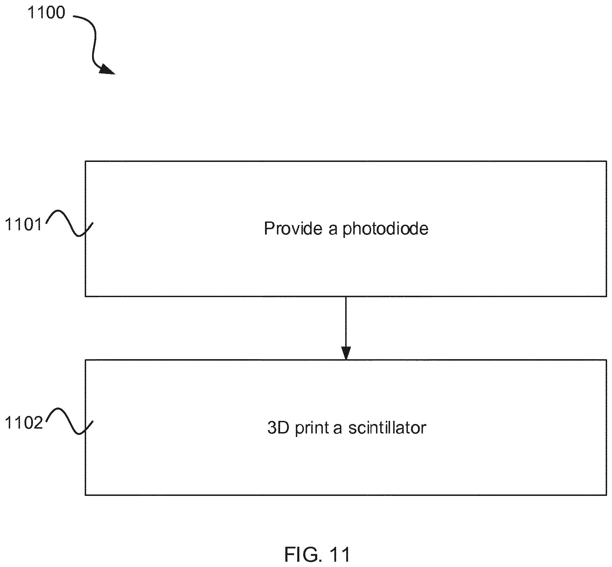

Fig. 11 illustrate a flow chart representation of a method for manufacturing a radiation detector according to an embodiment.

According to an embodiment, the method 1100 for manufacturing a radiation detector comprises: providing 1101 a photodiode layer comprising at least one pixel; and 3D printing 1102, using a polymer, a scintillator layer onto the photodiode layer, wherein scintillator layer comprises at least one geometrical shape comprising a scintillating material and the polymer, wherein the scintillating material is configured to convert incident ionising radiation into non-ionising electromagnetic radiation, and wherein the geometrical shape is configured to guide the converted electromagnetic radiation into the at least one pixel.

According to an embodiment, the method 1100 for manufacturing a radiation detector further comprises adding, before the 3D printing, the scintillating material into the polymer. In some embodiments, the scintillating material may be in a powder form.

Since the at least one geometrical shape 104 may be produced onto the photodiode layer 101 using 3D printing, the printed material can act as the scintillator and adhesive. Therefore optical glue, and with that the intermediate layer between the scintillator layer 103 and the photodiode layer 101 can be omitted. This may reduce light losses between the scintillator layer 103 and the photodiode layer 101.

The price of printable raw materials can be substantially lower than that of standard scintillators. In particular, UV curable print techniques can be suitable for 3D printing the at least one geometrical shape 104. However, in principle, any 3D print technique may be suitable. Many plastics, such as aromatic plastics like polyvinyl toluene (PVT) and polystyrene (PS), as well as some UV curable materials, containing florescent dies such as 2,5-Diphenyloxazole (PPO) and 1,4-bis(5-phenyloxazol-2-yl) benzene (POPOP), are natural scintillators. These materials can emit visible or UV light upon x-ray absorption. Therefore, expensive scintillator materials may be replaced with cheaper plastics that can be directly deposited onto the photodiode layer 101. This may be particularly useful for photodiode layers 101 that are most sensitive in the VIS and/or UV wavelength regions.

The scintillation capability of the print plastic may be increased by adding scintillator materials to the raw print materials. This may be particularly simple if the scintillator materials are present in powder or solution form, e.g. praseodymium-doped gadolinium oxysulfide (Gd₂O₂S:Pr), zinc selenide (ZnSe), or neutron absorbers such as boron-10 (¹⁰B) and gadolinium-157 (¹⁵⁷Gd). This approach may also be used to print scintillators of various emitting colours onto the same photodiode by adding different scintillating materials at different locations. This may enable multicolour x-ray or gamma ray imaging and energy specific scintillation. Hence, multi energy radiation detectors using a single scintillator layer and photodiode layer may be possible.

Another advantage of 3D printing scintillators into photodiodes may be that shape of the print can be arbitrarily adjustable. Therefore, scintillator shapes that are application specific, e.g. with trapezoidal sidewalls, or micro lenses may be possible, as well as individual scintillator for each photodiode pixel. Thus, pixelated scintillator may be produced possibly at a lower cost. Arbitrary shapes and micro lenses may not be possible or feasible with traditional scintillators, while pixelated scintillators can be more expensive due to higher production costs.

3D printed scintillators may also be deposited at increases thicknesses, such as several millimetres, or centimetre. This may allow to mitigate the possible disadvantage of lower absorption efficiency of plastics by increasing the x-ray absorption length and thus the overall efficiency of the scintillator layer 103.

The 3D printing 1102 may be performed, for example, using digital light processing (DLP), fused deposition modelling (FDM), stereolithography (SLA), binder jetting, selective laser sintering (SLS), selective laser melting (SLM), electron beam melting (EBM), and/or laminated object manufacturing (LOM).

Herein, the term "3D printing" may refer to, for example, various processes in which material is joined or solidified under computer control to create a three-dimensional object. For example, in 3D printing, material may be added, such as liquid molecules or powder grains, may be fused together. 3D printing may be performed layer by layer. 3D printing may also be referred to as three-dimensional printing or similar.

The polymer may be, for example, any polymer used in 3D printing. The polymer may be thermoplastic. The polymer may be ultraviolet curable.

The polymer may comprise, for example, acrylonitrile butadiene styrene (ABS), polylactic acid (PLA), polyvinyl alcohol (PVA), polyethylene terephthalate (PET), polyethylene terephthalate copolyester (PETT), high impact polystyrene (HIPS), nylon, thermoplastic elastomer (TPE), aromatic plastics like polyvinyl toluene (PVT) and polystyrene (PS), 2,5-Diphenyloxazole (PPO), and/or 1,4-bis(5-phenyloxazol-2-yl) benzene (POPOP).

Any range or device value given herein may be extended or altered without losing the effect sought. Also any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the embodiments described above may be combined with aspects of any of the other embodiments described to form further embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the scope of this specification, which is defined by the appended claims.

## Claims

1. A radiation detector (100), comprising:
a photodiode layer (101) comprising at least one pixel (102); and
a scintillator layer (103) comprising at least one geometrical shape (104) comprising a scintillating material and a polymer, wherein the scintillating material is configured to convert incident ionising radiation (105) into non-ionising electromagnetic radiation (106), and wherein the geometrical shape (104) is configured to guide at least part of the converted electromagnetic radiation (106) into the at least one pixel (102) using reflections inside the at least one geometrical shape; and
said radiation detector being **characterized by** a refractive index of the at least one geometrical shape (104) which varies in a plane of the photodiode layer (101).

2. The radiation detector (100) according to any preceding claim, wherein the at least one geometrical shape further comprises a reflective layer (110) situated on a surface of the at least one geometrical shape comprising a material that is reflective to the converted electromagnetic radiation.

3. The radiation detector (100) according to any preceding claim, wherein the at least one geometrical shape comprises a first surface (107) and a second surface (108) opposing the first surface, wherein a surface area of the first surface is greater than a surface area of the second surface, and wherein the second surface is closer to the photodiode layer than the first surface.

4. The radiation detector (100) according to any preceding claim, wherein the at least one geometrical shape comprises a first surface (107) and a second surface (108), wherein the first surface and/or the second surface is substantially convex.

5. The radiation detector (100) according to claim 4, wherein the first surface or the second surface is in contact with the photodiode layer (101).

6. The radiation detector (100) according to any preceding claim, wherein the at least one geometrical shape comprises a height and a width and a ratio between the height and the width is greater than one.

7. The radiation detector (100) according to any preceding claim, wherein the polymer comprises at least one of:
acrylonitrile butadiene styrene;
polylactic acid;
polyvinyl alcohol;
polyethylene terephthalate;
polyethylene terephthalate copolyester;
high impact polystyrene;
nylon; or
thermoplastic elastomer.

8. The radiation detector (100) according to any preceding claim, wherein the at least one geometrical shape comprises a first geometrical shape (104_1) and a second geometrical shape (104_2), wherein the first geometrical shape comprises a first scintillating material, and wherein the second geometrical shape comprises a second scintillating material.

9. The radiation detector (100) according to claim 8, wherein the first scintillating material is configured to convert a first wavelength range of the ionising radiation (105_1) into a first non-ionising electromagnetic radiation (106_1), and wherein the second scintillating material is configured to convert a second wavelength range of the ionising radiation (105_2) into a second non-ionising electromagnetic radiation (106_2).

10. The radiation detector (100) according to any preceding claim, wherein the polymer comprises the scintillating material.

11. A method (1100) for manufacturing a radiation detector, comprising:
providing (1101) a photodiode layer comprising at least one pixel; and
3D printing (1102), using a polymer, a scintillator layer onto the photodiode layer, wherein scintillator layer comprises at least one geometrical shape comprising a scintillating material and the polymer, wherein the scintillating material is configured to convert incident ionising radiation into non-ionising electromagnetic radiation, and wherein the at least one geometrical shape is configured to guide the converted electromagnetic radiation into the at least one pixel using reflections inside the at least one geometrical shape; and
**characterized in that**
a refractive index of the at least one geometrical shape varies in a plane of the photodiode layer.

12. The method (1100) for manufacturing a radiation detector according to claim 11, further comprising:
adding, before the 3D printing, the scintillating material into the polymer.

13. The method (1100) for manufacturing a radiation sensor according to claim 11 or claim 12, wherein the 3D printing is performed using one of:
stereolithography;
binder jetting;
fused deposition modelling;
digital light processing;
selective laser sintering; or
laminated object manufacturing.

## Patentansprüche

1. Strahlungsdetektor (100), umfassend:
eine Fotodiodenschicht (101), die zumindest ein Pixel (102) umfasst; und
eine Szintillatorschicht (103), die zumindest eine geometrische Form (104) umfasst, umfassend ein szintillierendes Material und ein Polymer, wobei das szintillierende Material konfiguriert ist, einfallende ionisierende Strahlung (105) in nicht ionisierende elektromagnetische Strahlung (106) umzuwandeln, und wobei die geometrische Form (104) konfiguriert ist, zumindest einen Teil der umgewandelten elektromagnetische Strahlung (106) in zumindest ein Pixel (102) zu leiten, unter Verwendung von Reflektionen innerhalb der zumindest einen geometrischen Form; und
wobei der Strahlungsdetektor durch einen Brechungsindex der zumindest einen geometrischen Form (104) charakterisiert ist, die in einer Ebene der Fotodiodenschicht (101) variiert.

2. Strahlungsdetektor (100) gemäß einem vorstehenden Anspruch, wobei die zumindest eine geometrische Form weiter eine reflektive Schicht (110) umfasst, die auf einer Oberfläche der zumindest einen geometrischen Form gelegen ist, umfassend ein Material, welches für die umgewandelte elektromagnetische Strahlung reflektiv ist.

3. Strahlungsdetektor (100) gemäß einem vorstehenden Anspruch, wobei die zumindest eine geometrische Form eine erste Oberfläche (107) und eine zweite Oberfläche (108), welche der ersten Oberfläche gegenüberliegt, umfasst, wobei eine Oberflächenfläche der ersten Oberfläche größer als eine Oberflächenfläche der zweiten Oberfläche ist, und wobei die zweite Oberfläche näher an der Fotodiodenschicht als die erste Oberfläche ist.

4. Strahlungsdetektor (100) gemäß einem vorstehenden Anspruch, wobei zumindest eine geometrische Form eine erste Oberfläche (107) und eine zweite Oberfläche (108) umfasst, wobei die erste Oberfläche und/oder die zweite Oberfläche im wesentlichen konvex ist.

5. Strahlungsdetektor (100) gemäß Anspruch 4, wobei die erste Oberfläche oder die zweite Oberfläche in Kontakt mit der Fotodiodenschicht (101) steht.

6. Strahlungsdetektor (100) gemäß einem vorstehenden Anspruch, wobei die zumindest eine geometrische Form eine Höhe und eine Breite umfasst, und ein Verhältnis zwischen der Höhe und der Breite größer als eins ist.

7. Strahlungsdetektor (100) gemäß einem vorstehenden Anspruch, wobei das Polymer zumindest eins umfasst von:
Acrylnitril-Butadien-Styrol;
Polymilchsäure;
Polyvinylalkohol;
Polyethylenterephtalat;
Polyethylenterephtalat-Copolyester;
High Impact Polystyrene;
Nylon; oder
thermoplastischem Polymer.

8. Strahlungsdetektor (100) gemäß einem vorstehenden Anspruch, wobei die zumindest eine geometrische Form eine erste geometrische Form (104_1) und eine zweite geometrische Form (104_2) umfasst, wobei die erste geometrische Form ein erstes szintillierendes Material umfasst, und wobei die zweite geometrische Form ein zweites szintillierendes Material umfasst.

9. Strahlungsdetektor (100) gemäß Anspruch 8, wobei das erste szintillierende Material konfiguriert ist, einen ersten Wellenlängenbereich der ionisierenden Strahlung (105_1) in eine erste nichtionisierende elektromagnetische Strahlung (106_1) umzuwandeln, und wobei das zweite szintillierende Material konfiguriert ist, einen zweiten Wellenlängenbereich der ionisierenden Strahlung (105_2) in eine zweite nichtionisierende elektromagnetische Strahlung (106_2) umzuwandeln.

10. Strahlungsdetektor (100) gemäß einem vorstehenden Anspruch, wobei das Polymer das szintillierende Material umfasst.

11. Verfahren (1100) zum Herstellen eines Strahlungsdetektors, umfassend:
Bereitstellen (1101) einer, zumindest ein Pixel umfassenden Fotodiodenschicht; und
3D-Drucken (1102), unter Verwendung eines Polymers, einer Szintillatorschicht auf die Fotodiodenschicht, wobei die Szintillatorschicht zumindest eine geometrische Form umfasst, die ein szintillierendes Material und das Polymer umfasst, wobei das szintillierende Material konfiguriert ist, einfallende ionisierende Strahlung in nicht ionisierende elektromagnetische Strahlung umzuwandeln, und wobei die zumindest eine geometrische Form konfiguriert ist, die umgewandelte elektromagnetische Strahlung in das zumindest eine Pixel unter Verwendung von Reflektionen innerhalb der zumindest einen geometrischen Form zu leiten; und
**dadurch gekennzeichnet, dass** ein Brechungsindex der zumindest einen geometrischen Form in einer Ebene der Fotodiodenschicht variiert.

12. Verfahren (1100) zum Herstellen eines Strahlungsdetektors gemäß Anspruch 11, weiter umfassend:
Hinzufügen des szintillierenden Materials in das Polymer vor dem 3-D-Druck.

13. Verfahren (1100) zum Herstellen eines Strahlungssensors gemäß Anspruch 11 oder Anspruch 12, wobei das 3-D-Drucken durchgeführt wird unter Verwendung von einem von:
Stereolithographie;
Freistrahlbindemittelauftrag;
Schmelzschichtungsmodellierung;
digitaler Lichtverarbeitung;
selektivem Lasersintern; oder
laminierter Objektherstellung.

## Revendications

1. Détecteur de rayonnement (100) comprenant :
une couche de photodiodes (101) comprenant au moins un pixel (102) ; et
une couche de scintillateur (103) comprenant au moins une forme géométrique (104) comprenant un matériau scintillant et un polymère, dans laquelle le matériau scintillant est configuré pour convertir un rayonnement ionisant incident (105) en un rayonnement électromagnétique non ionisant (106), et dans laquelle la forme géométrique (104) est configurée pour guider au moins une partie du rayonnement électromagnétique converti (106) dans l'au moins un pixel (102) en utilisant des réflexions à l'intérieur de l'au moins une forme géométrique ; et
ledit détecteur de rayonnement étant **caractérisé par** un indice de réfraction de l'au moins une forme géométrique (104) qui varie dans le plan de la couche de photodiodes (101).

2. Détecteur de rayonnement (100) selon la revendication précédente, dans lequel l'au moins une forme géométrique comprend en outre une couche réfléchissante (110) située sur une surface de l'au moins une forme géométrique comprenant un matériau qui réfléchit le rayonnement électromagnétique converti.

3. Détecteur de rayonnement (100) selon l'une quelconque des revendications précédentes, dans lequel l'au moins une forme géométrique comprend une première surface (107) et une deuxième surface (108) opposée à la première surface, dans lequel la superficie de la première surface est supérieure à la superficie de la deuxième surface, et dans lequel la deuxième surface est plus proche de la couche de photodiodes que la première surface.

4. Détecteur de rayonnement (100) selon l'une quelconque des revendications précédentes, dans lequel l'au moins une forme géométrique comprend une première surface (107) et une deuxième surface (108), dans lequel la première surface et/ou la deuxième surface sont sensiblement convexes.

5. Détecteur de rayonnement (100) selon la revendication 4, dans lequel la première surface ou la deuxième surface est en contact avec la couche de photodiodes (101).

6. Détecteur de rayonnement (100) selon l'une quelconque des revendications précédentes, l'au moins une forme géométrique a une hauteur et une largeur et le rapport entre la hauteur et la largeur est supérieur à un.

7. Détecteur de rayonnement (100) selon l'une quelconque des revendications précédentes, dans lequel le polymère comprend au moins l'un parmi :
un acrylonitrile-butadiène-styrène ;
un poly(acide lactique) ;
un poly(alcool vinylique) ;
un poly(téréphtalate d'éthylène) ;
un copolyester de poly(téréphtalate d'éthylène) ;
un polystyrène choc ;
un nylon ; ou
un élastomère thermoplastique.

8. Détecteur de rayonnement (100) selon l'une quelconque des revendications précédentes, dans lequel l'au moins une forme géométrique comprend une première forme géométrique (104_1) et une deuxième forme géométrique (104_2), dans lequel la première forme géométrique comprend un premier matériau scintillant, et dans lequel la deuxième forme géométrique comprend un deuxième matériau scintillant.

9. Détecteur de rayonnement (100) selon la revendication 8, dans lequel le premier matériau scintillant est configuré pour convertir une première gamme de longueurs d'onde du rayonnement ionisant (105_1) en un premier rayonnement électromagnétique non ionisant (106_1), et dans lequel le deuxième matériau scintillant est configuré pour convertir une deuxième gamme de longueurs d'onde du rayonnement ionisant (105_2) en un deuxième rayonnement électromagnétique non ionisant (106_2).

10. Détecteur de rayonnement (100) selon l'une quelconque des revendications précédentes, dans lequel le polymère comprend le matériau scintillant.

11. Procédé (1100) pour fabriquer un détecteur de rayonnement, comprenant :
la fourniture (1101) d'une couche de photodiodes comprenant au moins un pixel ; et
l'impression 3D (1102), utilisant un polymère, d'une couche de scintillateur sur la couche de photodiodes, dans laquelle la couche de scintillateur comprend au moins une forme géométrique comprenant un matériau scintillant et un polymère, dans laquelle le matériau scintillant est configuré pour convertir un rayonnement ionisant incident en un rayonnement électromagnétique non ionisant, et dans laquelle l'au moins une forme géométrique est configurée pour guider le rayonnement électromagnétique converti dans l'au moins un pixel en utilisant des réflexions à l'intérieur de l'au moins une forme géométrique ; et
**caractérisé en ce que** l'indice de réfraction de l'au moins une forme géométrique varie dans le plan de la couche de photodiodes.

12. Procédé (1100) pour fabriquer un détecteur de rayonnement selon la revendication 11, comprenant en outre :
l'addition, avant l'impression 3D, du matériau scintillant dans le polymère.

13. Procédé (1100) pour fabriquer un détecteur de rayonnement selon la revendication 11 ou la revendication 12, dans lequel l'impression 3D est effectuée par utilisation de l'un parmi :
une stéréolithographie ;
une projection de liant ;
un dépôt de fil fondu ;
un traitement à la lumière numérique ;
un frittage au laser sélectif ; et
une fabrication d'objet stratifié.
